# EUROPEAN PATENT APPLICATION

(11) **EP 1 672 687 A1**
(43) Date of publication of application: **21.06.2006**
(21) Application number: 05447015.8
(22) Date of filing: 02.02.2005
(51) Int. Cl.: H01L 21/764, H01L 21/8249, H01L 27/06

(54) **Formation of deep airgap trenches and related applications**

(30) Priority: 17.12.2004 US 637288 P
(71) Applicant: INTERUNIVERSITAIR MICROELEKTRONICA CENTRUM ( IMEC), 3001 Leuven (BE)
(72) Inventor: Kunnen, Eddy, 3010 Kessel-LO (BE)
(74) Representative: Van Malderen, Joëlle

(57) **Abstract**

A method for forming deep trench or via airgaps in a semiconductor substrate is disclosed comprising the steps of patterning a hole in the substrate, partly fill said hole with a sacrificial material (e.g. poly-Si), depositing spacers on the sidewalls of the unfilled part of the hole (e.g. TEOS) to narrow the opening, removing through said narrowed opening the remaining part of the sacrificial material (e.g. by isotropic etching) and finally sealing the opening of the airgap by depositing a layer (TEOS) above the spacers.

The method of forming an airgap is demonstrated successfully for use as deep trench isolation structures in BiCMOS devices.

## Description

### Field of the invention

The present invention relates to a method of forming trenches or vias in semiconductor devices, which are filled with a gas (or mixture of at least two gases), more particularly with air, also referred to as airgaps.

The present invention also relates to a device obtainable by a method according to the invention.

### Background

The semiconductor industry is continuously reducing the dimensions of the devices. In Back End Of Line (BEOL) processing, it concerns the reducing dimensions of conductive layers as well as the separation of the different conductive structures to each other.

Isolation of these structures becomes therefore extremely important and low-k materials replace conventional dielectric insulating materials and the trend is to move on to the incorporation of air, so called air regions or airgaps, as isolation material for conductive structures.

Examples of airgaps incorporated in BEOL structures are based on the removal of sacrificial material through a porous capping layer. The sacrificial material is evaporated through the porous capping layer and sealed afterwards by deposition of an extra layer. Examples of these methods are described in US 6,165,890 and US 6,287,979.

In Front End Of Line (FEOL) processing isolation of the active device areas is one of the critical issues when dimensions are reduced. The device isolation methodology has been changed or modified several times with the aim of enhancing density or device functionality. Many of them had certain process limitations and where not very scalable. The introduction of the "trench isolation technology" has been accepted quickly by industry as the primary isolation technique for advanced device and circuit designs (US 4,104,086).

For bipolar or BiCMOS technologies, device isolation is in particular important because the collector nodes, which are buried in the substrate, carry active signals. This is in contrast with MOS transistors, where the wells don't carry active signals. The collectors are isolated from the substrate by collector-substrate pn junctions. This junction has a box-like shape with a bottom surface determined by the transistor area and a lateral surface determined by both the transistor perimeter and the n-type region depth. It introduces a parasitic junction capacitance at the collector terminal. The value of the parasitic is given by the sum of a perimeter term, associated with the lateral junction, and an area term, associated with the bottom junction.

Deep trench isolation structures have been since a long time commonly used in advanced bipolar technologies in order to reduce the total device area and to reduce the collector to substrate parasitic capacitance. The introduction of a deep trench filled with an insulator around the bipolar transistor replaces the lateral junction with a silicon-insulator-silicon capacitor and it can be used to reduce the value of the perimeter component of the capacitance. As the transistor dimensions are scaled down, the total value of the capacitance is also effectively reduced because the percent weight of the perimeter component increases.

The reduction of the collector-substrate capacitance allows further optimization of the high-speed or low-power performance of bipolar transistors. In common-emitter stages designed in a low-power bipolar technology, the collector-substrate capacitance forms a significant contribution to the total switching delay. A low collector-substrate capacitance value helps to obtain state-of-the-art power-delay products. Other applications that can benefit from the introduction of deep trench isolation are for instance high voltage applications, to realize high breakdown voltage or to isolate high voltage regions from low voltage regions and applications where good latch-up immunity or low substrate noise is desired.

In a full BiCMOS technology the deep trench has to be etched, refilled and planarized with a CMOS compatible process module. This fact sets constraints on the selection of the process steps and on the location of the module in the complete process flow. The trench isolation technology is based on four key process elements: trench formation, trench lining, trench filling and trench planarization. In particular the choice of the filling material is very important, as it determines the value of the actual capacitance of the collector substrate perimeter component. LOW-*k* materials are desired, with silicon dioxide being the most straightforward candidate. Although a complete oxide filling is preferred, because of its good isolation properties and low dielectric constant, this scheme is not easy to implement for several reasons: it is difficult to obtain a complete fill of the deep trench without leaving any voids and secondly a completely oxide filled deep trench would generate localized stresses and defects during and after processing.

For these reasons, a state-of-the-art deep trench module nowadays often consists of a combined oxide/poly-silicon filling. The poly-silicon material makes it easier to fill the trench properly and thermal stress is reduced because the thermal expansion coefficient of polysilicon and the silicon substrate match much better. However, the isolation qualities are less (the κ-value of polysilicon is roughly a factor 3 higher than that of oxide). For that reason, it is beneficial to increase the oxide/poly-silicon ratio as much as possible, as this will reduce the final collector to substrate perimeter capacitance. One of the ways to accomplish this in a modern CMOS technology with a shallow trench isolation scheme is the introduction of the deep trench isolation prior to the shallow trench one. In this way, the thickness of the oxide liner in the deep trench can be well balanced with respect to possible stress generation and obtaining a low perimeter capacitance value, without affecting the CMOS shallow trench isolation module itself.

Alternatively, as described by Washio et al (IEEE Transactions on Electronic devices, Vol. 48, 2001), double deep trenches can be used, at the expense of increased device area.

### Summary

A method for forming airgaps (7) in a semiconductor substrate is disclosed comprising the steps of:
- patterning a hole in said substrate (1),
- filling partly said hole with a sacrificial material (4),
- forming spacers (5) on the sidewalls of the unfilled part of the hole to narrow the opening,
- removing at least part of said sacrificial material (4) through said narrowed opening, and
- sealing the opening by depositing a sealing layer (6) above said spacers.

In a method of the invention, the filling step can comprise (or consist of) the steps of filling completely said hole with sacrificial material and then removing (more particularly etching back) partly said sacrificial material to obtain a partly filled holed. Preferably, removal of said sacrificial material is performed by means of an isotropic etching process.

Preferably, said sacrificial material is poly-silicon.

The step of forming spacers (5) can comprise (or consist of) two steps : first depositing a layer that closes or (substantially) narrows the opening, preferably by means of any suitable conformal deposition process, and second etching back said layer allowing said spacers formation. Said etching back step in the spacers formation steps, can be performed by any suitable etching process, and preferably by means of an anisotropically dry etching process.

In a method of the invention, the sealing step can be performed by any suitable deposition process.

For example, said sealing step can be performed by CVD, etc.

Preferably, the sealing layer (6), deposited for sealing the opening, is TEOS (Tetra Ethyl Ortho Silicate, Si(OC₂H₅)₄), which can also be referred to as TEOS-oxide.

A method of the invention can further comprise a step of planarizing said sealing layer (6) by means of Chemical Mechanically Planarization or Polishing.

A method for forming an airgap trench according to the invention can be applied in particular for deep trench isolation in BiCMOS applications.

The present invention also provides a semiconductor device obtainable by a method of the invention.

In particular, a semiconductor device is provided comprising a hole filled with a gas (or mixture of at least two, three, four or more gases), more particularly with air, said hole, etched in the substrate and optionally in at least one protecting layer, is sealed partly by means of spacers deposited upon the sidewall of said hole and partly by means of a sealing layer deposited upon said spacers.

A semiconductor device of the invention can be a BiCMOS device.

Carrying out a method of the invention allows the reduction of the parasitic collector substrate perimeter capacitance by introducing an airgap in the trench.

The airgap trench makes it possible to reduce the width of the deep trench and thus reduce the total device area while keeping the collector substrate capacitance unchanged.

### Brief description of the drawings

All drawings are intended to illustrate some aspects and embodiments of the present invention. Devices are depicted in a simplified way for reason of clarity. Not all alternatives and options are shown and therefore the invention is not limited to the content of the given drawings. Like numerals are employed to reference like parts in the different figures.

Figures 1A to 1H illustrate the different processing steps for forming an airgap using a method of the present invention.

Figures 2A to 2K illustrate the different processing steps for the integration of the deep airgap trenches for BiCMOS applications.

Figure 3 shows a SEM picture illustrating the formation of spacers (5) to narrow the opening of the partly filled hole.

Figure 4 shows a SEM picture illustrating the formation of the deep airgap trench (7) after spacer formation and removal of the poly-silicon sacrificial material by isotropic etching.

Figure 5 shows a SEM picture illustrating the formation of the deep airgap trench (7) after removal of the poly-silicon sacrificial material by isotropic etching and deposition of a TEOS-oxide conformal sealing layer (6) (deposited by Chemical Vapor deposition) to close/seal the airgap (7).

Figure 6 shows a more detailed SEM picture illustrating the deposited conformal TEOS sealing layer (6) (by Chemical Vapor deposition) to close the airgap (7).

Figure 7 illustrates a SEM picture (PRIOR ART) showing a classical deep isolation trench in the substrate (18) filled with a combination of TEOS-oxide (20) and poly-silicon (19) in a BiCMOS device. The bipolar transistors (21) are also indicated.

Figure 8 illustrates a SEM picture showing the deep isolation trench (7) of the present invention integrated in a BiCMOS device.

### Detailed description of the invention

The following description illustrates a method for forming an airgap and its applications. It will be appreciated that there are numerous variations and modifications possible. Accordingly, the description should not be deemed to limit the scope of the invention, which is defined by the claims.

The present invention provides a method for forming airgaps in a semiconductor substrate comprising the steps of:
- patterning a trench or a hole in said substrate,
- filling partly said hole with a sacrificial material,
- forming spacers on the sidewalls of the unfilled part of the hole to narrow the opening,
- removing through said narrowed opening at least part of said sacrificial material, and
- sealing the opening by depositing a layer of a suitable material above said spacers.

Before the step of patterning a trench/hole in the substrate, one, two, three or more protecting layers can be deposited upon the substrate. This protecting layer(s) can be of any suitable material able to protect the substrate from any possible damages that the further steps may generate.

For example, said layer(s) can act as a mask layer in further etching steps, or can act as a protective layer in CMP processes, etc.

The trench or hole patterned may vary in terms of depth and width.

Depending on the application, the depth may vary for example from about 100 nm to about 100 *µ*m, preferably from about 500 nm to about 15 *µ*m, and the smallest dimension (e.g. width) may vary for example from about 100 nm to about 100 *µ*m, preferably from about 200 nm to about 10 *µ*m; any value comprised between these extremes being encompassed in the scope of the present invention.

Also depending on the application, the trench/hole can be etched in such a way that the deeper into the substrate the smaller its width.

In the context of the present invention, the term "sacrificial material" refers to a material (or a layer) that is deposited temporarily, that is not supposed to remain (at least totally) in the final device, in other words that is destined to be removed, at least partially and/or locally. This material has to be removed, at least partially and/or locally, by any suitable means.

In a method of the invention, the sacrificial material can be of any material that can be deposited in the trench/hole and can be (selectively) removed through the opening left after the spacers formation.

For example, said sacrificial material can be amorphous silicon, oxide, etc. Preferably, said sacrificial material is poly-silicon.

Said sacrificial material can be deposited by any suitable processes, and for example by CVD.

Said hole patterned can be filled partly or fully.

In case of a partial filling, the removal of the sacrificial material, before the spacers formation, is optional.

In case of a complete filling, the sacrificial material is removed at least partially (before the spacers formation), preferably by an isotropic etching step. Also in this case, optionally, the sacrificial material can be first planarized (before being removed) by CMP (Chemical Mechanical Polishing).

Before depositing said sacrificial material, a method of the invention can further comprise a step of depositing at least one separating layer, preferably in the hole.

Said separating layer(s) can be of any suitable material that can resist the subsequent etching steps (carried out for removing the sacrificial material) and thus prevent the substrate from being damaged.

In particular, a separating layer is needed when the sacrificial material is such that it cannot be or is difficult to remove selectively towards the substrate. For example, where the trench surface is Si, said separating material can be an oxide layer grown upon said Si trench surface by means of a thermal or wet oxidation.

Moreover, and optionally, an additional (extra) oxide liner, also referred to as an additional/extra protecting layer, can be deposited directly upon the substrate or upon the protecting layer(s) and/or upon the separating layer(s). Said extra oxide liner can be of any suitable material and for example can be a TEOS-oxide layer.

In a method of the invention, the extra oxide liner possibly deposited as an additional protective layer for the substrate, can also be used as a stopping layer for CMP (Chemical Mechanical Polishing) performed to planarize the sacrificial material.

In the context of the present invention, the term "spacer(s)" refers to a material (or layer) that is deposited on the sidewall(s) of said trench/hole (partially filled with said sacrificial material) in order to narrow the opening.

The step of forming spacers (5) can comprise (or consist of) two sub-steps : first depositing a layer (spacers material) that closes or (substantially) narrows the opening, preferably by means of any suitable conformal deposition process, and then etching back said layer (spacers material) allowing said spacers formation. Said etching back step in the spacers formation, can be performed by any suitable etching process, and preferably by means of an anisotropically dry etching process.

Said spacers can be of any suitable material, which is capable of resisting the subsequent step of removing the sacrificial material.

Said spacers can be for example TEOS-oxide, more particularly when said sacrificial material is poly-silicon.

Optionally, for dry etch endpoint triggering, a nitride liner (or layer) can be deposited before the spacers are deposited. Preferably, said nitride liner is a thin layer deposited by means of a conformal deposition process.

After the step of forming the spacers, the sacrificial material present in the hole is removed, through the narrowed opening, by means of any suitable process, more particularly by an isotropic etching process.

After the step of removing the sacrificial material, the sealing step can be performed by any suitable deposition process.

Said deposition process is preferably a CVD process.

Preferably, the layer deposited for sealing the opening, also referred to as sealing layer, is TEOS.

A method of the invention can further comprise a step of planarizing said sealing layer by means of Chemical Mechanically Planarization/Polishing.

By carrying out a method according to the invention, an airgap is created that is situated within the substrate.

In the context of the present invention, the term "airgap" refers to said trench/hole sealed partly by means of said spacers deposited upon the sidewalls of said hole and partly by means of said sealing layer, wherein said hole is filled with a gas (or a mixture of two, three, four or more gases), and preferably with air.

Said gas may comprise gaseous reaction byproducts originating from different reactions occurring during the different steps of a method of the invention.

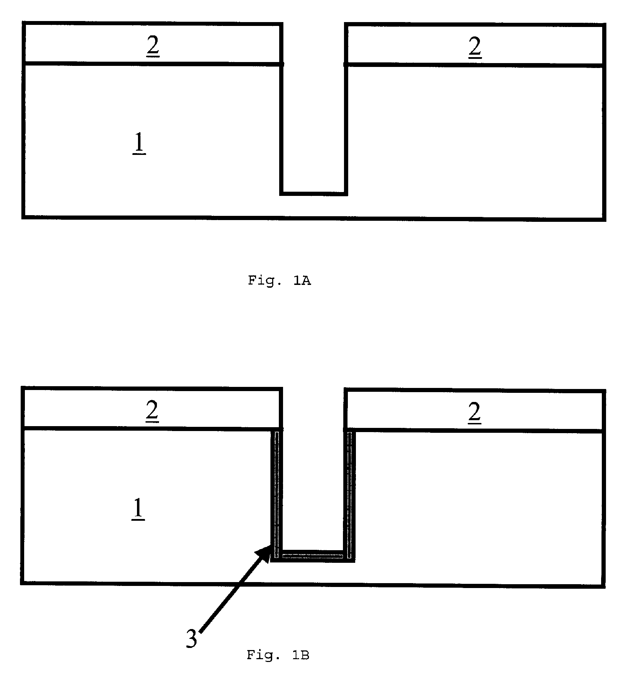

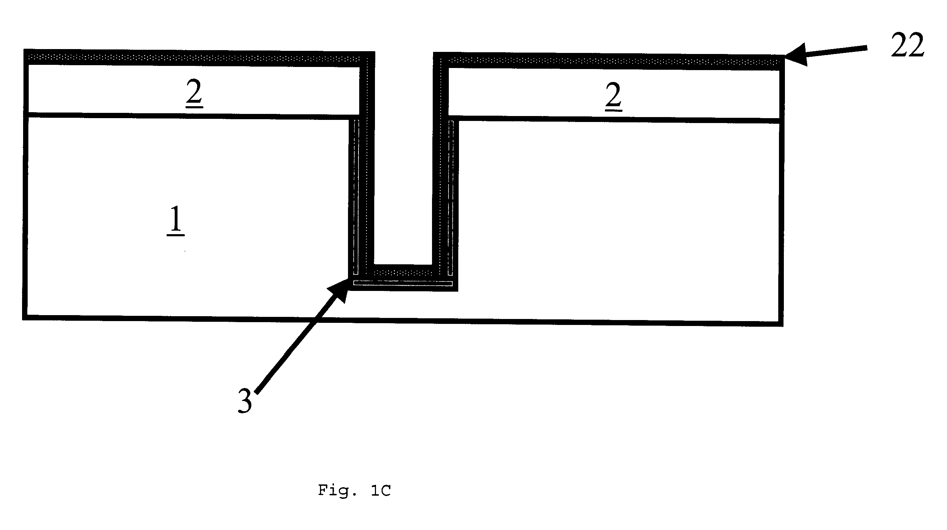

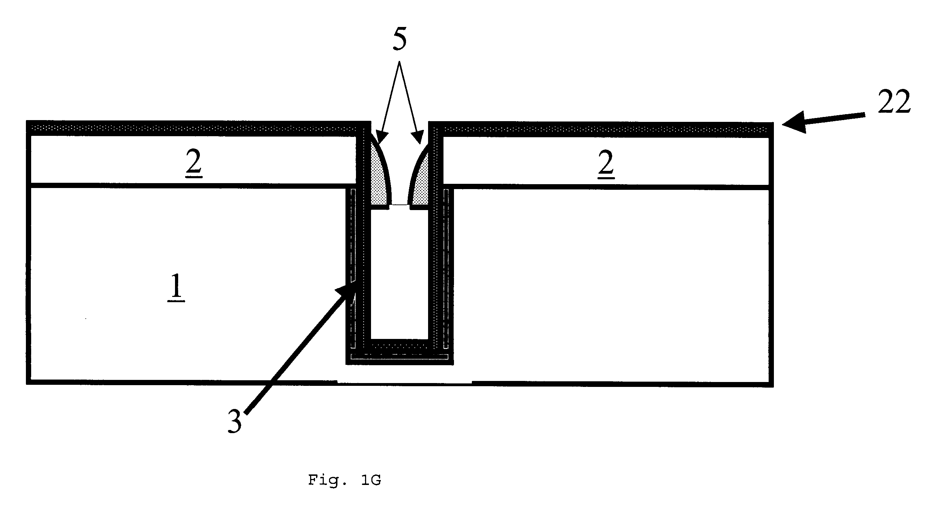

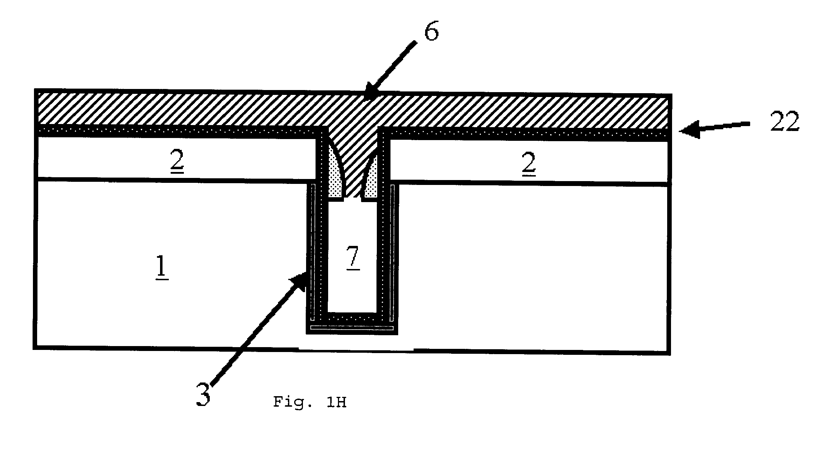

In a first embodiment, a method according to the invention for forming the airgap is described and is schematically represented by Figures 1A to 1H.

The substrate (1), as represented on the figures 1A to 1H is preferably a Si wafer.

Said substrate (1) can be a bare silicon wafer or a silicon wafer with extra layers deposited on top of it such as an epitaxial growth layer (which is the case for example in BiCMOS applications).

To protect the substrate (1), a protecting layer (2) is deposited upon said substrate (1).

Subsequently said protecting layer (2) and the substrate (1) are patterned.

For trench isolation, a trench (or hole) is patterned.

Preferably, the trench/hole is etched in such a way that the deeper into the substrate the smaller its width. Such a tapered trench allows better void and less filling.

Preferably, the anisotropic patterning is done by dry etch (reactive plasma based).

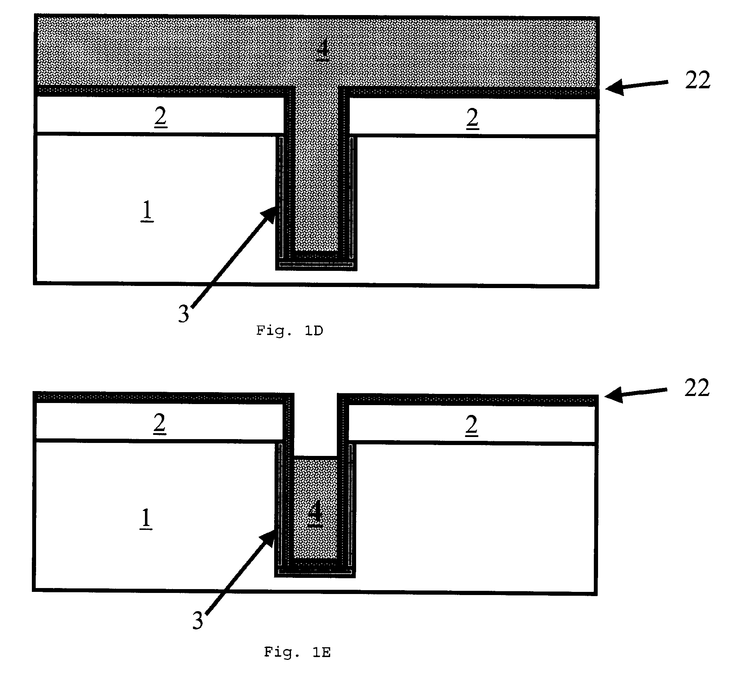

As shown in figure 1B and 1C, a separating layer (3) is formed/deposited in the trench.

This separating layer (3) is needed when the sacrificial material (4) is difficult to remove selectively towards the substrate (1).

Said separating layer (3) can be a oxide layer grown on the Si trench surface by means of a thermal or wet oxidation. Preferably, said oxide layer has a thickness of about 20 nm.

Additionally an extra oxide liner (22) of variable thickness (preferably less than about 300 nm) is deposited (Figure 1C).

This deposited extra oxide liner/layer (22) can act as an additional protective layer during patterning or during wet removal.

Said extra oxide liner (22) can be for example a TEOS-oxide layer.

Subsequently, the sacrificial material (4) is deposited to fill the trench/hole (Figure 1D).

Said sacrificial material (4) can be a poly-silicon layer deposited by any suitable means upon said extra oxide liner (22). Preferably, said poly-silicon layer has a thickness of about 1200 nm.

Chemical Mechanical Planarization/Polishing (CMP) is used to planarize this sacrificial material (4) with the protecting layer acting as a stopping layer. Other techniques such as dry etch or wet etch can be used as well.

Said sacrificial material (4) in the trench is then removed (e.g. by means of etchback), preferably till a level below the top of the protecting layer (2) such that a partly filled trench is created (see Figure 1E).

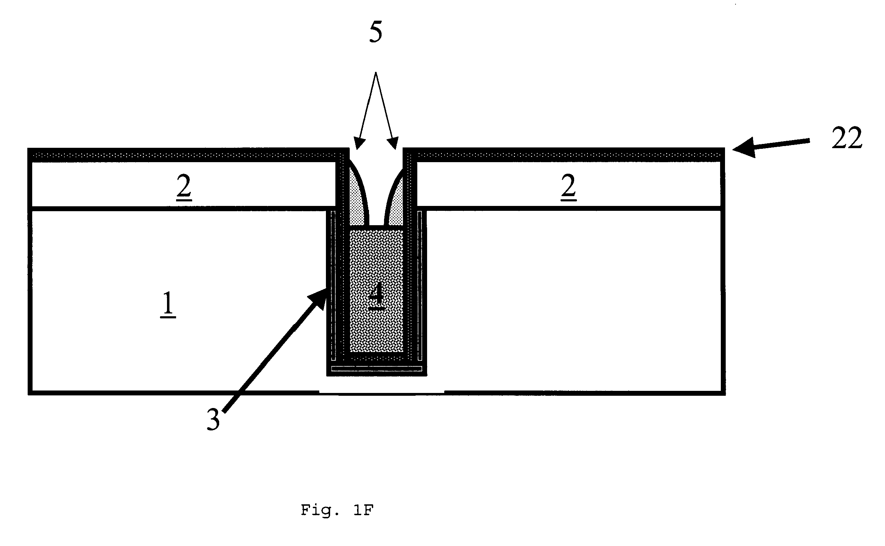

In Figure 1F, spacers (5) are formed to narrow the opening of the trench/hole.

The spacers are formed by a deposition process followed by an etchback.

The material used for said spacers can be an oxide, more specifically TEOS-oxide.

For dry etch endpoint triggering a nitride liner can be deposited first. Said nitride liner can be a 10 nm layer.

Preferably, the distance between the spacers (5) after spacer formation (in other words the width of the opening) can vary between about 50 nm and about 200 nm.

After spacer formation, the sacrificial material (4) is removed through the opening, between the spacers (Figure 1G). Said sacrificial material (4) is thus replaced by a gas (or mixture of at least two gases), preferably by air.

Said gas may comprise gaseous reaction byproducts originating from different reactions occurring during the different steps of a method of the invention.

The sacrificial material (4), made preferably of poly-silicon, is removed e.g. by a SF₆ based isotropic dry etch plasma.

Other reactive gas techniques such as down stream etching can be suitable as well.

Basically, the sacrificial material (4) is converted into a gas that can leave through the opening between the spacers.

If oxide is used as protective layer (3) and/or (22) the etching must be selective towards oxide.

Finally, the opening between the spacers is sealed by a deposition process.

A conformal oxide deposition can be used for depositing a sealing layer (6). An example of sealing layer (6) is a TEOS layer deposited by Chemical Vapor Deposition.

Figure 1H shows the airgap (7) formed after sealing the opening.

As a side effect, a small amount of TEOS can be deposited inside the trench.

The deposited sealing layer (6) can be further planarized (e.g. by doing chemical mechanical planarization/polishing), stopping on protecting layer (2).

By doing this an airgap (7) is created that is situated completely in the substrate.

In an alternative embodiment, the method starts by depositing a combination of protecting layers onto the substrate 1.

Said protecting layers can comprise an oxide layer on top of a nitride layer, the latter being on top of another oxide layer. Said other oxide layer is on top of the substrate 1.

Subsequently the protecting layers and the substrate are patterned.

The further steps are the steps of a method of the invention. In particular, the other steps can be as described in the previous embodiment.

As already described, in a method of the invention, and as another possible alternative, the deposition of the sacrificial material (4) is such that a partly filled trench is created and no further etchback is needed.

### BiCMOS devices with airgaps

A method of the present invention for forming airgaps can be successfully applied for the formation of deep trench airgaps for an active area - field isolation module in a BiCMOS device.

BiCMOS deep trenches have a typical trench depth of 6 micron and a CD of about 1 micron.

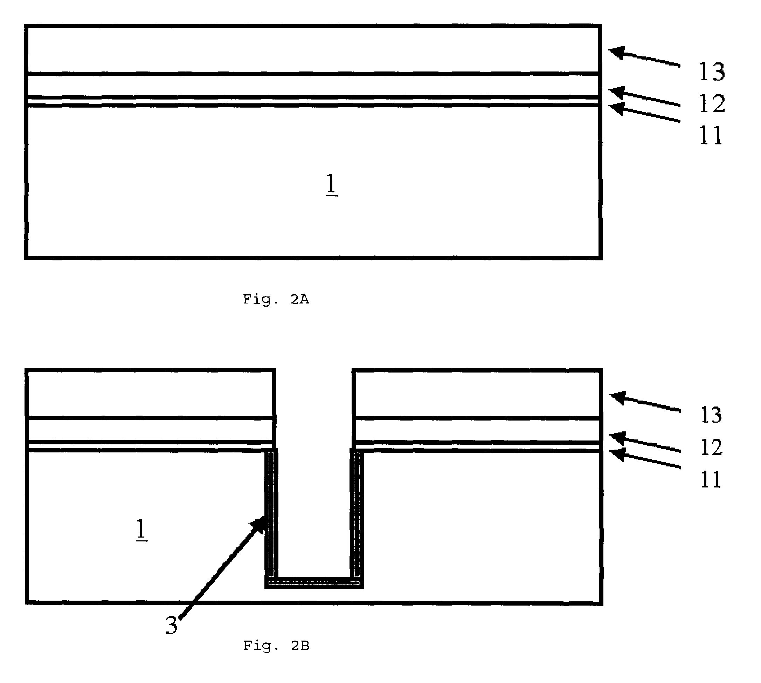

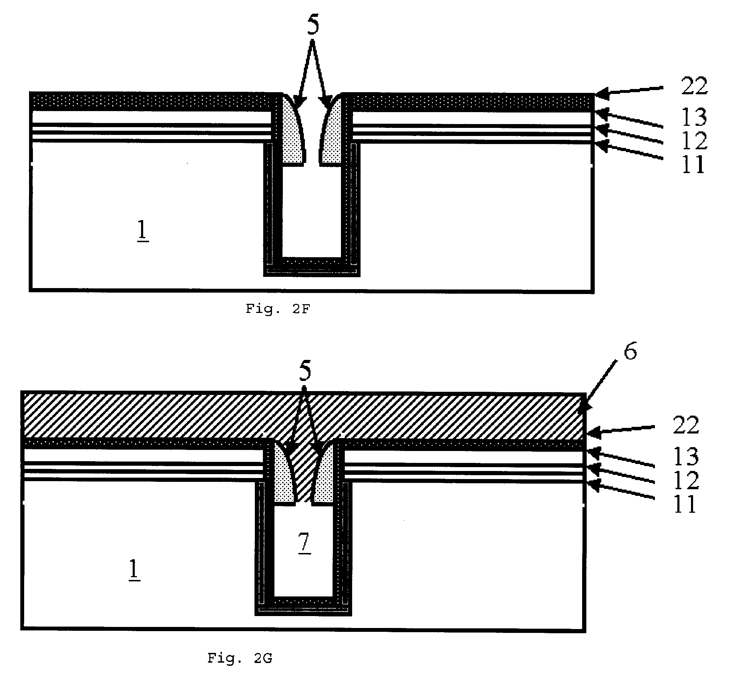

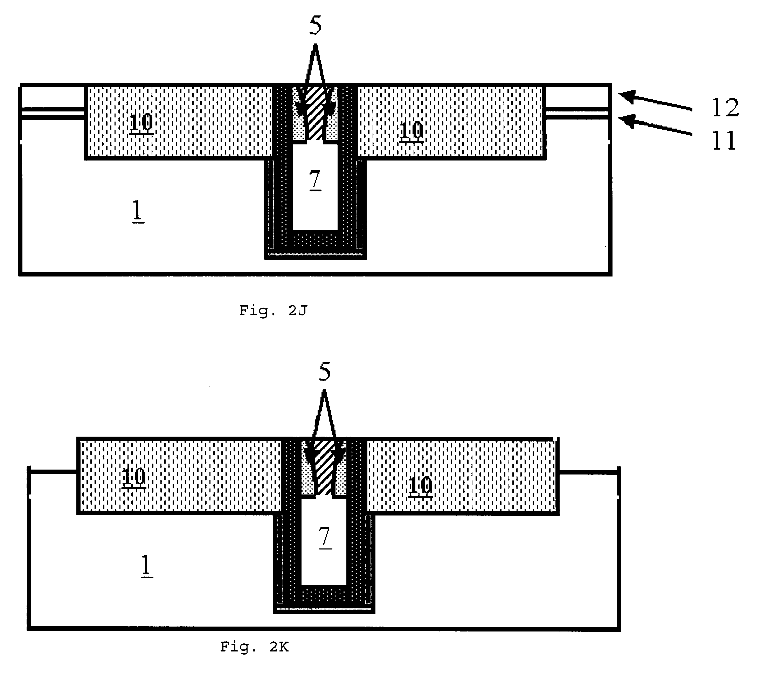

The different processing steps for the integration of the deep airgap trenches for BiCMOS applications are illustrated in Figures 2A to 2K.

First an oxide layer (11) is deposited on top of the Si substrate (1) . Preferably, said oxide layer (11) has a thickness of less than about 25 nm, and more preferably has a thickness of about 10 nm.

A nitride layer (12) is then deposited on the oxide layer (11) (Figure 2A). Preferably, said nitride layer (12) has a thickness of less than about 300 nm, and more preferably has a thickness of about 115 nm.

The oxide layer (11) is needed to prevent strain effects from the nitride (12) into the substrate.

The nitride layer (12) can serve as an active protecting nitride layer (APN) during CMP steps.

On top of the APN (12) a second oxide layer (13) is deposited. Preferably, said second oxide layer (13) has a thickness of less than about 5 micron, more preferably has a thickness comprised between about 100 nm and about 500 nm, and more preferably has a thickness of about 300 nm.

This oxide layer (13) can serve as a mask for subsequent etching, more particularly as a hardmask for trench/hole etching. Subsequently the protecting layers (11), (12) and (13) and the substrate (1) are patterned.

Then a separating layer (3) is formed within the patterned structure. This separating layer (3) is needed in cases where the sacrificial material (4) is difficult to remove selectively towards the substrate (1) (Figure 2B).

Said separating layer (3) is grown on the Si trench surface by means of a thermal or wet oxidation. Preferably said separating layer (3) has a thickness of about 20 nm.

Additionally, an extra oxide liner (22) is deposited upon said separating layer (3). The thickness of said extra oxide liner (22) can vary to reach about 500 nm or even more depending on the application, and preferably is less than about 300 nm.

Preferably, said extra oxide liner (22) is a TEOS-oxide layer.

Subsequently, the sacrificial material (4) is deposited to fill the trench/hole.

Said sacrificial material (4) is preferably deposited to form a 1200 nm poly-silicon layer upon said extra oxide liner (22).

Chemical Mechanical Polishing (CMP) is used to planarize this material. Said extra oxide liner (22) can then act as a stopping layer.

However other techniques such as dry etch or wet etch can be suitable as well.

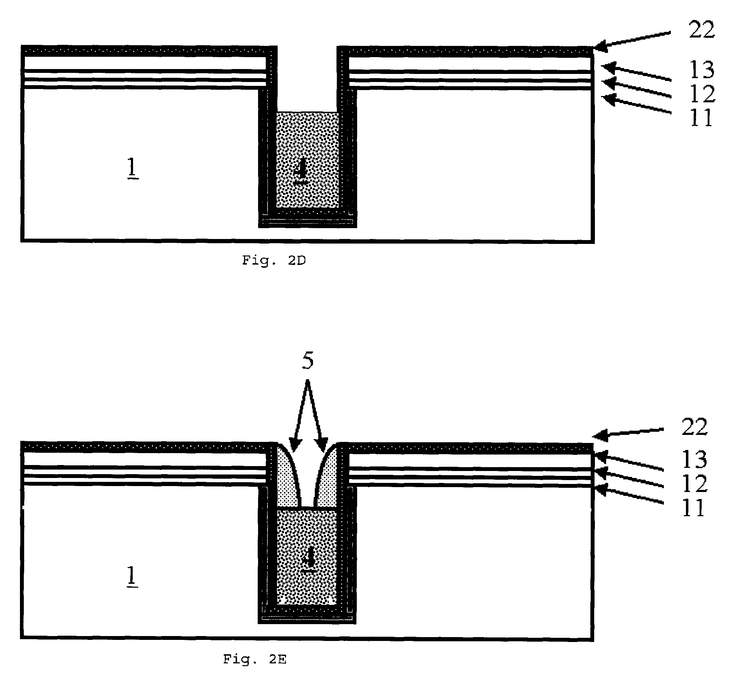

The sacrificial material (4) is removed (e.g. by means of etchback) till a level below the top of the protecting layers (11), (12) and (13) such that a partly filled trench is created (Figure 2D).

Spacers (5) are then formed to narrow the opening of the trench (Figure 2E). The spacers (5) are formed by deposition process followed by anisotropic dry etch.

Preferably, an oxide spacer is formed, more specifically TEOS-oxide spacers are formed.

A nitride liner can be deposited first, before the spacers formation, for acting as a dry etch endpoint. Said nitride liner can have a thickness of about 10 nm.

After spacers formation the distance between the spacers (or the width of the opening) is preferably comprised between about 50 nm and about 200 nm.

After said anisotropic dry etching step, the sacrificial material (4) is removed through the opening, between the spacers (Figure 2F).

Preferably, the sacrificial material (4) is poly-silicon and is removed for example by a SF₆ based isotropic dry etch plasma.

Other reactive gas techniques such as down stream etching and wet etching can be suited as well.

Basically, the sacrificial material (4) is converted into a gas that can leaves through the opening between the spacers (5).

The etching (or removal of said sacrificial material (4)) must be selective towards oxide.

Finally, the ,opening between the spacers is sealed by a deposition process.

The sealing layer (6) is preferably deposited by means of a conformal oxide deposition process. Said sealing layer (6) can be for example a TEOS layer deposited by a Chemical Vapor Deposition process.

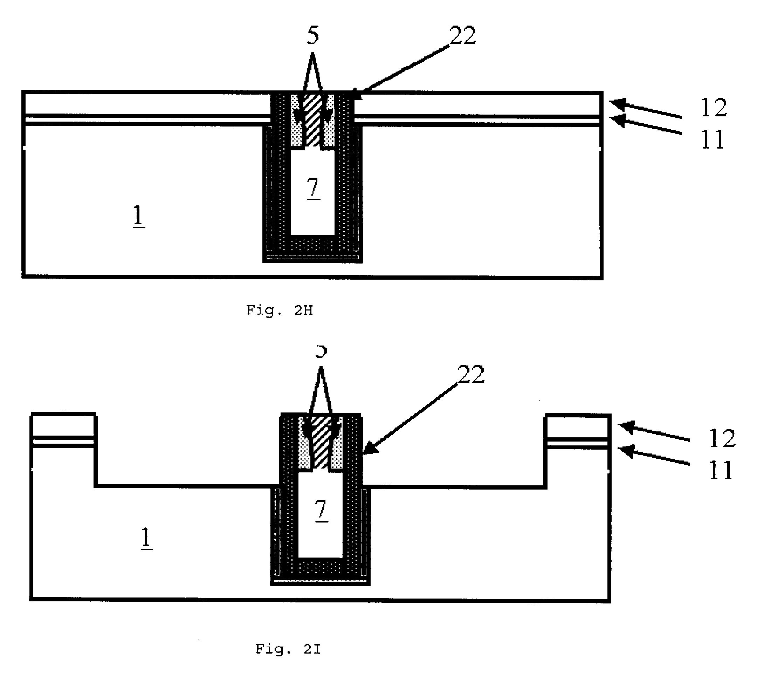

The processing continues with planarization of the sealing layer (6) by CMP, stopping on the APN (12) (Figure 2H).

Subsequently, the field area is patterned.

The field area is patterned by putting a lithographic photo (248-193 nm) followed by dry etch of the layers (11) and (12) and the substrate (1) (Figure 21).

Typically the etch depth in the substrate is 300-400 nm.

Layers (11) and (12) can be dry etched with fluor based chemistry (e.g. CF₄, C₂F₆, CHF₃, CH₂F₂, SF₆, etc.).

Preferably, the substrate dry etch is based upon a Cl/HBr/O₂/He/N₂ chemistry and has good selectivity towards oxide.

In order to have good filling, the etch in the substrate (1) has preferably a slope.

Filling the field areas with a field oxide (10) and planarization of this oxide (10) are the next steps (Figure 2J).

Finally, the APN (12) and the oxide layer (11) are removed from the active area.

The present invention also provides a semiconductor device obtainable by a method according to the invention.

A semiconductor device of the invention comprises an airgap obtainable by a method of the invention.

A semiconductor device of the invention comprises a hole filled with a gas (or mixture of at least two, three, four or more gases), more particularly with air, said hole, etched in the substrate and possibly in at least one protecting layer, is sealed partly by means of spacers deposited upon the sidewall of said hole, and partly by means of a sealing layer deposited upon said spacers.

Preferably, said hole further comprises a separating layer, and optionally an extra protecting layer, deposited on its walls (side and bottom walls).

Preferably, said trench/hole is patterned such that the width of the trench/hole decreases while said trench/hole goes deeper into the substrate.

Preferably, the substrate comprises (or consists of) silicon.

Preferably, said separating layer, said extra protecting layer, said spacers and/or said sealing layer comprise(s) (or consist(s) of) tetraethyl orthosilicate (TEOS).

In particular, a device according to the invention can be a BiCMOS (bipolar complementary metal oxide semiconductor) device, which comprises a first field area and a second field area, wherein said sealed hole is between said first field area and said second field area.

A BiCMOS device of the invention can comprise:
- a substrate having a trench therein, the trench having walls and a bottom,
- an airgap enclosed in the trench in the substrate the airgap having a top, a bottom, and sides, and
- a first field area and a second field area, wherein said airgap is situated between said first field area and said second field area.

In a BiCMOS device of the invention, said airgap is enclosed by a first portion of spacers and a second portion of a conform(al) layer, wherein the spacers and the conform(al) layer seal the opening of the trench.

Preferably, said trench further comprises an oxide separating layer, and optionally an extra oxide liner, deposited on its walls (side and bottom walls).

Preferably, said trench is tapered such that the width of the trench decreases while going deeper into the substrate.

Preferably, the substrate comprises (or consists of) silicon.

Preferably, said oxide separating layer, said extra oxide layer, said spacers and/or said conform(al) layer comprise(s) (or consist(s) of) tetraethyl orthosilicate (TEOS).

Preferably, said first field area and/or said second field area are planarized.

Preferably, said first field area and said second field area comprise each an oxide.

### The invention can also be described as follows.

A method for forming airgaps in a semiconductor substrate comprising the steps of patterning a hole in the substrate and partly or completely fill said hole with a sacrificial material (e.g. poly-Silicon), depositing spacers on the sidewalls of the unfilled part of the hole (e.g. TEOS-oxide) to narrow the opening, removing through said narrowed opening the remaining part of the sacrificial material (e.g. by isotropic etching) and finally sealing the opening of the airgap by depositing a conform layer (TEOS-oxide) above the spacers. In case of a complete filling of the patterned hole, the material will be etched back partly to end up with a partly filled hole.

The method for forming an airgap trench is applied for deep trench isolation in BiCMOS applications. Here the aim of the invention is to provide a novel method of further reducing the parasitic collector substrate perimeter capacitance by introducing an airgap in the trench. The airgap trench makes it possible to reduce the width of the deep trench and thus reduce the total device area while keeping the collector substrate capacitance unchanged.

A method for forming airgaps in a substrate is provided comprising the steps of:
- patterning a hole in the substrate (1),
- partly or completely fill said hole with a sacrificial material (4),
- depositing spacers (5) on the sidewalls of the unfilled part of the hole to narrow the opening,
- removing through said narrowed opening the remaining part of the sacrificial material (4),
- sealing the opening of the airgap by depositing a conform layer (6) above the spacers, and
- optionally planarizing the deposited layer by means of a removal process.

In a method of the invention, the completely filled hole with sacrificial material is etched back partly to create a partly filled hole.

Said sacrificial material (4) is preferably poly-silicon.

Preferably, said spacers (5) to narrow the opening of said hole are made of TEOS.

Preferably, the removal of the sacrificial material (4) is done by an isotropic etching process.

Preferably, the sealing of the airgap is performed by a deposition process, more particularly a CVD process.

Preferably, the sealing layer is TEOS.

In a method of the invention the sealing layer can be planarized by means of Chemical Mechanically Planarization.

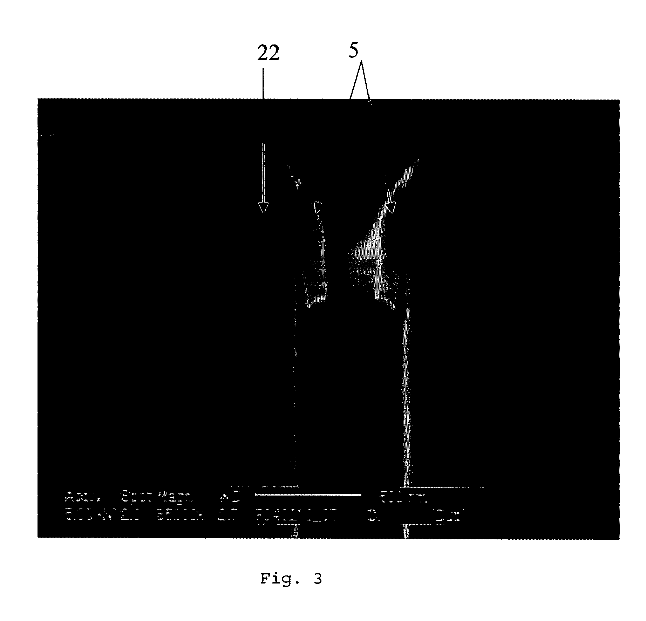

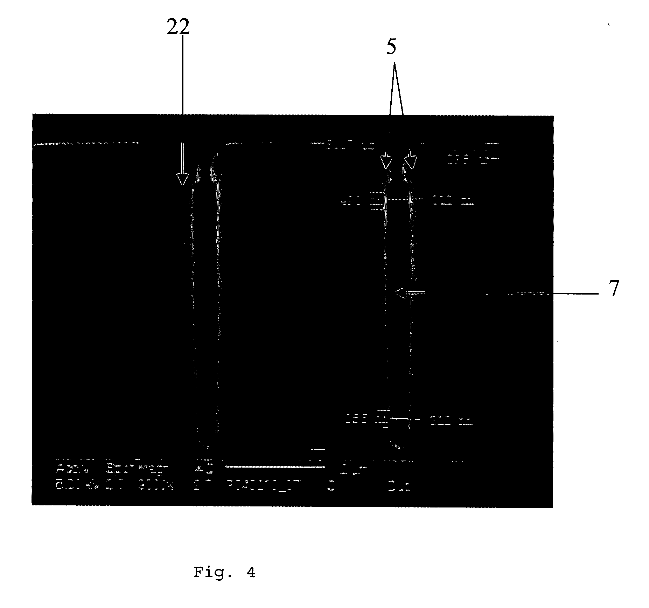

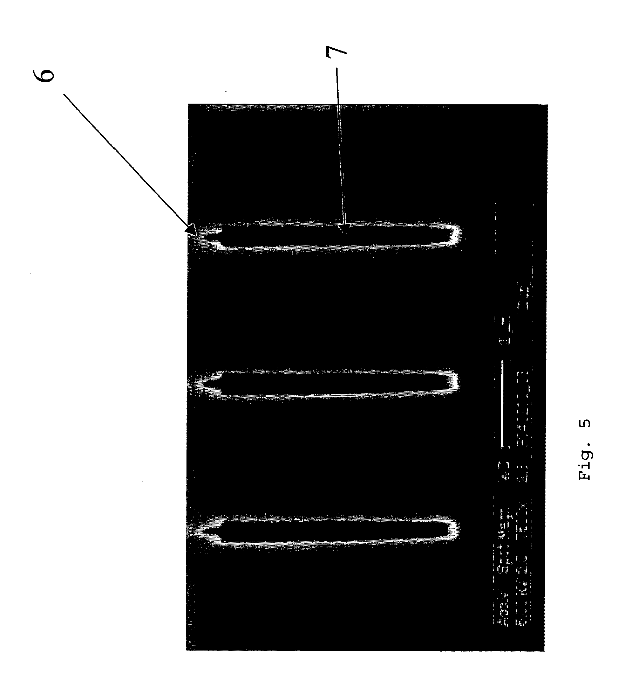

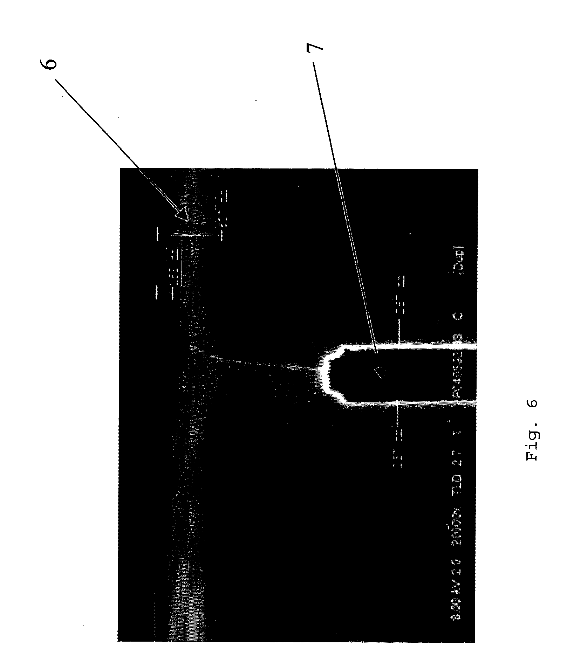

In a first embodiment, the method for forming the airgap is described. The method is schematically presented in Figures 1A to 1H. In the presented case, the substrate 1 is a Si wafer. Said substrate can be a bare silicon wafer or a silicon wafer with extra layers deposited on top of it such as an epitaxial growth layer (e.g. in BiCMOS applications). If the substrate 1 needs to be protected, a protecting layer 2 is deposited. Subsequently the protecting layer and the substrate are patterned. For trench isolation a trench is patterned. The trench is etched in such a way that the width becomes smaller if you go deeper into the substrate. Such a tapered trench allows better void less filling. In the example shown, the anisotropic patterning is done by dry etch (reactive plasma based). As shown in figure 1B and 1C, a separating layer is formed in the trench, this layer is needed in case it is difficult to remove the sacrificial material 4 selectively towards the substrate 1. In the presented case, first a 20 nm oxide as separating layer is grown on the Si trench surface (Figure 1B) by means of a thermal or wet oxidation. Additionally an extra oxide liner 22 can be deposited of variable thicknesses (0-300nm) as shown in Figure 1C. This deposited liner can act as additional protective layer during patterning or during wet removal. In the presented case the deposited oxide liner is TEOS-oxide (Tetra Ethyl Ortho Silicate, Si(OC₂H₅)₄). Subsequently, the sacrificial material 4 is deposited to fill the trench (see Figure 1D). In the presented case 1200 nm of poly-silicon is deposited. Chemical Mechanical Polishing (CMP) is used to planarize this material with the protecting layer as a stopping layer, however other techniques such as dry etch or wet etch could be suitable as well. The sacrificial material 4 in the trench is removed (e.g. by means of etchback) till a level below the top of the protecting layer 2 such that a partly filled trench is created (see Figure 1E). In Figure 1F, spacers 5 are formed to narrow the opening of the trench. The spacers are formed by a deposition process followed by an etchback. In the presented case, an oxide spacer is formed, more specifically TEOS-oxide spacers. For dry etch endpoint triggering a 10 nm nitride liner is deposited first. In the presented case, the distance between the spacers after spacer formation is of the order of 50 - 200 nm. Figure 3 shows a SEM picture illustrating the formation of spacers to narrow the opening of the partly filled hole. The spacers 5 are indicated as well as the oxide liner 22. After spacer etching the sacrificial material is removed through the opening formed between the spacers (see Figure 1G). In the presented case, the sacrificial material is poly-silicon and is removed e.g. by a SF₆ based isotropic dry etch plasma. Other reactive gas techniques such as down stream etching can be suitable as well. Basically, the sacrificial material is converted into a gas that can leave through the opening between the spacers. If oxide is used as protective layer the etching must be selective towards oxide. Figure 4 shows a SEM picture illustrating the formation of the deep airgap trench 7 after removal of the sacrificial material (poly-silicon) through the narrowed opening by isotropic etching. Finally, the opening between the spacers is sealed by a deposition process. In the presented case a conformal oxide deposition 6 is used (TEOS by Chemical Vapor Deposition). Figure 1H shows the airgap 7 formed after sealing the opening. As a side effect, a small amount of TEOS will be deposited inside the trench. The deposited sealing layer 6 can be further planarized (e.g. by doing chemical mechanical planarization) stopping on protecting layer 2. By doing this an airgap is created that is situated completely in the substrate. Figure 5 and 6 show SEM pictures illustrating the airgap trench after removal of the sacrificial material (poly-silicon) by isotropic etching and deposition of a conformal layer 6 (e.g. TEOS deposition by Chemical Vapor deposition) to close the airgap.

In an alternative embodiment, the method starts by depositing a combination of protecting layers onto the substrate 1. This is shown schematically in Figures 2A- 2H. The protecting layers can comprise a 300 nm oxide layer 13 on top of 115 nm nitride layer 12 on top of a 10 nm oxide layer 11 on top of the substrate 1. Subsequently the protecting layers and the substrate are patterned. Further processing is identical as described in the previous embodiment.

In another alternative embodiment the deposition of the sacrificial material 4 is such that a partly filled trench is created and no further etchback is needed.

### BiCMOS devices with airgaps

The method of the present invention for forming airgaps is successfully applied for the formation of deep trench airgaps for an active area - field isolation module in a BiCMOS device. BiCMOS deep trenches have a typical trench depth of 6 micron and a CD of about 1 micron.

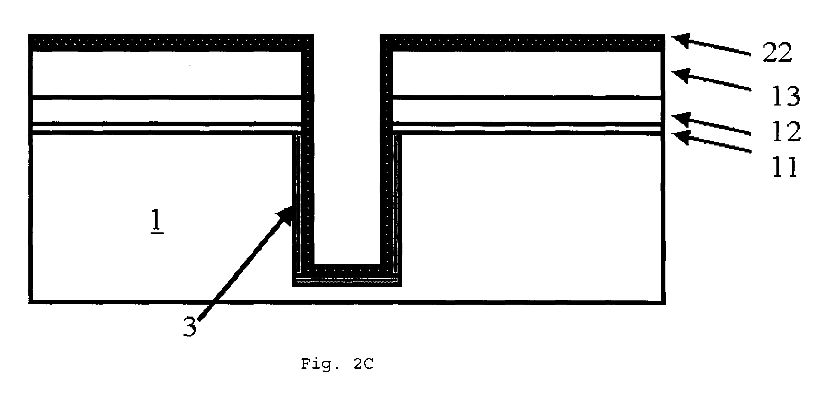

The different processing steps for the integration of the deep airgap trenches for BiCMOS applications are illustrated in Figures 2A to 2K. First a 10 nm oxide layer 11 is deposited on top of the Si substrate 1. A 115 nm nitride layer 12 is deposited on the oxide layer (see Figure 2A). The oxide layer 11 is needed to prevent strain effects from the nitride 12 into the substrate. The nitride layer 12 will serve as an active protecting layer (APN) during CMP steps. On top of the APN a 300 nm oxide layer 13 is deposited. This oxide layer 13 will serve as a mask for subsequent etching. Subsequently the protecting layers and the substrate are patterned. As shown in Figure 2B and 2C, then a separating layer 3 is formed within the patterned structure, this layer is needed in the case it is difficult to remove the sacrificial material 4 selectively towards the substrate 1. In the presented case, first a 20 nm oxide 3 as separating layer is grown on the Si trench surface (Figure 1B) by means of a thermal or wet oxidation. Additionally an extra oxide liner 22 can be deposited of variable thicknesses (0-300nm). In this particular case, the oxide liner is TEOS-oxide (TetraEthylOrthosilicate, Si (OC₂H₅)₄). Subsequently, the sacrificial material 4 is deposited to fill the trench. In the presented case 1200 nm of poly-silicon is deposited. Chemical Mechanical Polishing (CMP) is used to planarize this material with the protecting layer as a stopping layer, however other techniques such as dry etch or wet etch could be suitable as well. The sacrificial material 4 within the trench is removed (e.g. by means of etchback) till a level below the top of the protecting layer such that a partly filled trench is created (see Figure 2D). In Figure 2E spacers 5 are formed to narrow the opening of the trench. The spacers are formed by deposition process followed by anisotropic dry etch. In the presented case, an oxide spacer is formed, more specifically TEOS-oxide spacers. For dry etch endpoint triggering a 10 nm of nitride liner is deposited first. After spacer formation the distance between the spacers is of the order of 50 - 200 nm. After spacer etching the sacrificial material is removed through the opening formed between the spacers (see Figure 2F). In the presented case, the sacrificial material is poly-silicon and is removed (e.g. by a SF₆ based isotropic dry etch plasma). Other reactive gas techniques such as down stream etching and wet etching can be suited as well. Basically, the sacrificial material is converted into a gas that can leaves through the opening between the spacers 5. The etching must be selective towards oxide. Finally, the opening between the spacers is sealed by a deposition process. In the presented case a conformal oxide deposition 6 is used (TEOS by Chemical Vapor Deposition). The processing continues with planarisation of the sealing layer 6 by CMP stopping on the APN 12 (Figure 2H). Subsequently, the field area is patterned. The field area is patterned by putting a lithographic photo (248-193 nm) followed by dry etch of the layers 11 and 12 and the substrate 1 (see Figure 21). Typically the etch depth in the substrate is 300-400 nm. Layers 11 and 12 can be dry etched with fluor based chemistry (e.g. CF₄, C₂F₆, CHF₃, CH₂F₂, SF₆,...) . In the presented case, the substrate dry etch is based upon a Cl/HBr/O₂/He/N₂ chemistry and has good selectivity towards oxide. In order to have good filling, the etch in the substrate has a slope. Filling the field areas with a field oxide 10 and planarization of this oxide is the next step (Figure 2J). Finally, the APN 12 and the oxide layer 11 are removed from the active area.

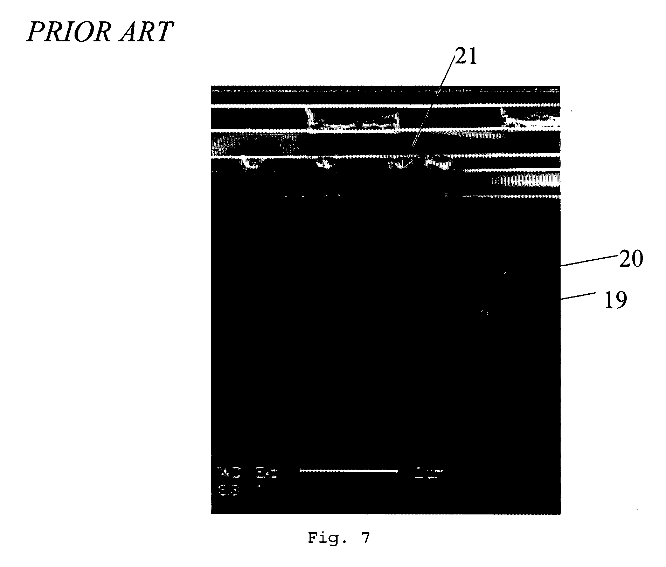

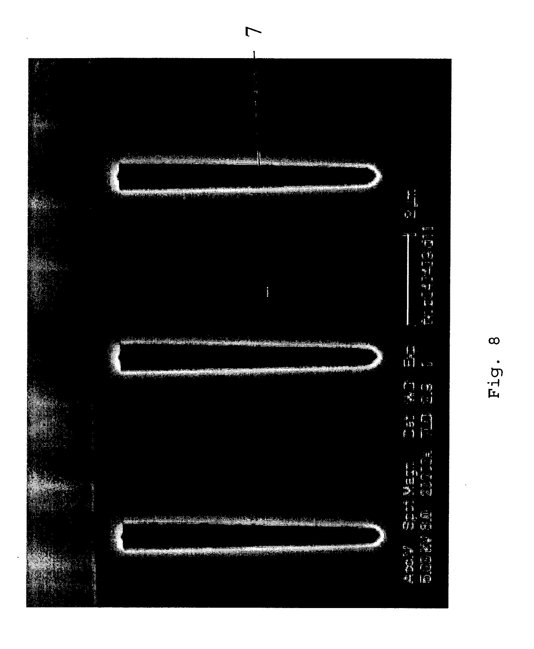

Figure 7 illustrates a SEM picture (PRIOR ART) of a BiCMOS device with a classical deep isolation trench in the substrate 18 filled with a combination of TEOS-oxide 20 and poly-silicon 19 in a BiCMOS device. Figure 8 illustrates a SEM picture showing the deep isolation trench of the present invention integrated in the same BiCMOS device.

### Other applications for deep airgap trenches/vias

The method of the present invention for making deep airgap trenches can be applied for several other applications within semiconductor processing.

Next to trenches the present invention is also valid to form airgap vias or other types of structures.

The method for making the deep trench airgap of the present invention can be formed at any level within the semiconductor circuit, taking thermal budget in consideration, which implies replacement of some materials into lower temperature deposition materials. After sealing the airgap normal FEOL and/or BEOL processing can be performed depending on the application.

Deep trench airgaps can be used in high-voltage technology wherein the airgap deep trench can be used for isolation of the high-voltage devices NPN, PNP and vertical DMOS from the substrate. The airgap deep trench has higher breakdown voltage and lower capacitance towards the substrate. Alternatively, the trench width can be reduced for the same breakdown and capacitance, hence saving chip area.

Deep trench airgaps can be used in high-voltage technology wherein the airgap deep trench can be used for device termination, such as used in integrated super-junction devices. These devices are prone to breakdown at the perimeter, when the device is not properly terminated. In this case, the deep trench has to reach the buried layer n-type. The advantage of the airgap deep trench is again higher breakdown voltage, or alternatively a smaller deep trench for same breakdown voltage.

Deep trench airgaps can be used in Mixed Signal and RF technology, the airgap deep trench isolation might be used here for suppression of substrate cross-talk. The switching noise of the digital circuitry on these chips degrades the spectral purity of the sensitive analog and RF blocks, and the airgap deep trench isolation can be used to isolate these regions better, since it is an isolation method with low capacitance towards the substrate. Placing a network of airgap deep trench isolation under on-chip inductors, transformers and transmission line improves the RF performance of these components, through the reduction of eddy currents in the substrate and decreasing the capacitive coupling of these components towards the substrate.

### EXAMPLES

Figure 3 shows a SEM picture illustrating the formation of spacers to narrow the opening of the partly filled hole.

The spacers (5) are indicated as well as the extra oxide liner (22).

Figure 4 shows a SEM picture illustrating the formation of the deep airgap trench (7) after removal of the poly-silicon sacrificial material (4) through the narrowed opening by isotropic etching.

Figures 5 and 6 show SEM pictures illustrating the airgap trench (7) after removal of the poly-silicon sacrificial material (4) by isotropic etching and deposition of a TEOS conformal sealing layer (6) (deposition by Chemical Vapor deposition) to close the airgap.

Figure 7 illustrates a SEM picture (PRIOR ART) of a BiCMOS device with a classical deep isolation trench in the substrate (18) filled with a combination of TEOS-oxide (20) and poly-silicon (19) in a BiCMOS device.

Figure 8 illustrates a SEM picture showing the deep isolation trench (7) of the present invention integrated in a BiCMOS device.

## Claims

1. A method for forming airgaps (7) in a substrate (1) comprising the steps of:
- patterning a hole in said substrate (1),
- filling partly said hole with a sacrificial material (4),
- forming spacers (5) on the sidewalls of the unfilled part of the hole to narrow the opening,
- removing at least part of said sacrificial material (4) through said narrowed opening, and
- sealing the opening by depositing a sealing layer (6) above said spacers.

2. A method according to claim 1, wherein said hole is first completely filled with said sacrificial material (4) which is then partly etched back to obtain a partly filled hole.

3. A method according to claim 1 or 2, further comprising the step of depositing at least one protecting layer (2) upon said substrate (1), before the patterning step.

4. A method according to any of claims 1 to 3, further comprising the step of depositing at least one separating layer (3) in said hole.

5. A method according to claim 3 or 4, further comprising the step of depositing at least one extra protecting layer (22) upon said protecting layer(s) (2) and/or upon said separating layer(s) (3).

6. A method according to any of claims 1 to 5, wherein the step of forming said spacers (5) comprises the steps of:
- optionally depositing a nitride layer as a dry etch endpoint triggering, then
- closing or narrowing the opening by depositing a spacers material upon said hole, and
- anisotropically etching back said spacers material allowing spacers formation.

7. A method according to any of claims 1 to 6, wherein said sacrificial material (4) is removed by an isotropic etching process.

8. A method according to any of claims 1 to 7, wherein said sealing layer (6) is deposited by a conformal deposition process.

9. A method according to claim 8, wherein said conformal deposition process is a CVD process.

10. A method according to any of claims 1 to 9, further comprising a step of planarizing said sealing layer (6).

11. A method according to claim 10, wherein said planarizing step is performed by means of Chemical Mechanically Planarization.

12. A method according to any of claims 1 to 11, wherein said substrate (1) is silicon.

13. A method according to any of claims 1 to 12, wherein said sacrificial material (4) is poly-silicon.

14. A method according to any of claims 1 to 13, wherein said spacers material, said extra protecting layer (22), and/or said sealing layer (6) is/are made of TEOS-oxide.

15. A semiconductor device obtainable by a method according to any of claims 1 to 14.

16. A bipolar complementary metal oxide semiconductor device, the device comprising:
- a substrate having a trench therein, the trench having walls and a bottom, an airgap enclosed in the trench in the substrate the airgap having a top, a bottom, and sides
- and a first field area and a second field area, wherein the airgap is situated between the first field area and the second field area.

17. A bipolar complementary metal oxide semiconductor device according to claim 16 wherein the top of said airgap is enclosed by a first portion of spacers and a second portion of a conform layer, the spacers and the conform layer sealing the opening of said trench.

18. A bipolar complementary metal oxide semiconductor device according to claim 16 or 17, wherein an oxide separating layer is formed atop the walls and the bottom of said trench.

19. A bipolar complementary metal oxide semiconductor device according to any of claims 16 to 18, further comprising an extra oxide liner atop the oxide separating layer.

20. A bipolar complementary metal oxide semiconductor device according to any of claims 16 to 19, wherein said trench is tapered such that the deeper into the substrate the smaller its width.

21. A bipolar complementary metal oxide semiconductor device according to any of claims 16 to 20, wherein said substrate comprises silicon.

22. A bipolar complementary metal oxide semiconductor device according to any of claims 16 to 21, wherein the conform layer comprises tetraethyl orthosilicate.

23. A bipolar complementary metal oxide semiconductor device according to any of claims 16 to 22, wherein the oxide separating layer comprises tetraethyl orthosilicate.

24. A bipolar complementary metal oxide semiconductor device according to any of claims 16 to 23, wherein the extra oxide layer comprises tetraethyl orthosilicate.

25. A bipolar complementary metal oxide semiconductor device according to any of claims 16 to 24, wherein the spacers comprise tetraethyl orthosilicate.

26. A bipolar complementary metal oxide semiconductor device according to any of claims 16 to 25, wherein the first field area comprises a planarized first field area and wherein the second field area comprises a planarized second field area.

27. A bipolar complementary metal oxide semiconductor device according to any of claims 16 to 26, wherein the first field area and the second field area each comprise an oxide.
